# EUROPEAN PATENT SPECIFICATION

(11) **EP 0 384 644 B1**
(45) Date of publication and mention of the grant of the patent: **03.05.1995**
(21) Application number: 90301612.9
(22) Date of filing: 15.02.1990
(51) Int. Cl.: H05K 1/02, H05K 1/16, H05K 9/00

(54) **Printed circuit board**
Gedruckte Leiterplatte
Plaque de circuit imprimé

(30) Priority: 21.02.1989 JP 19218/89 U; 21.02.1989 JP 19219/89 U; 21.02.1989 JP 19220/89 U; 21.02.1989 JP 40836/89; 21.02.1989 JP 40837/89; 21.02.1989 JP 40838/89
(43) Date of publication of application: 29.08.1990
(60) Divisional application: 94202845.7
(73) Proprietor: TATSUTA ELECTRIC WIRE & CABLE CO., LTD., Higashiosaka-shi, Osaka-fu (JP)
(72) Inventor: Nakatani, Fumio, Yamatokoriyama-shi, Nara-ken (JP); Wakita, Shinichi, Akashi-shi, Hyogo-ken (JP); Murakami, Hisatoshi, Higashiosaka-shi, Osaka-fu (JP); Terada, Tsunehiko, Ikeda-shi, Osaka-fu (JP); Morimoto, Shohei, Hishiyahigashi-Ryo, Tatsuta Elec, Higashiosaka-shi, Osaka-fu (JP)
(74) Representative: Beresford, Keith Denis Lewis

(56) References cited:
- EP-A- 0 238 267
- EP-A- 0 259 785
- DE-A- 1 936 899
- FR-A- 2 527 039
- IBM TECHNICAL DISCLOSURE BULLETIN, vol. 30, no. 4, September 1987, page 1558, Armonk New York, US: "Method to form an electromagnetic shield on a component-populated electronic circuit board"

## Description

### Background of the Invention

### (Field of the Invention)

This invention relates to a printed circuit board e.g. for use in electronic equipment, such as a printed circuit board for which electromagnetic interference (EMI) preventing means is taken.

### (Description of the Prior Art)

The recent progress of electronic equipments is facilitating the trend toward increase of operation speed and density of circuit formed as printed circuit board, as a result which regulations are becoming more severe. One of the typical EMI preventing means which are conventionally applied is to reduce the radiation noise and incoming noise by covering printed circuit board with the shield case.

However, this method causes a problem that the electromagnetic wave energy enclosed in the shield case is emitted outwards through cables. Moreover, since this method is not basically intended to reduce the electromagnetic wave energy which is generated due to high frequency characteristics of circuit. Therefore it is almost impossible to completely suppress the radiation noise. Hence, a new printed circuit board against EMI has been proposed (USP4,801,489 = EP-A-0 238 267). This printed circuit board features that an insulation layer (hereinafter this insulation layer is called the undercoat layer) is formed, excepting at least a part of ground pattern, on a substrate on which a signal line pattern (hereinafter referred to as signal pattern), a ground line pattern (herein after referred to as ground pattern) and a power line pattern (hereinafter referred to as power supply pattern) are formed, and a conductive layer such as conductive paste layer is formed thereon so as to be connected to an uninsulated part of the ground pattern.

Usually, another insulation layer (hereinafter referred to as overcoat layer) is formed on this conductive layer.

Radiation noise can be reduced in the printed circuit boards of such a configuration mainly for the following four reasons.

Firstly, reduction of ground pattern impedance by conductive layer.

Secondly, removal of high frequency component from signal pattern and power supply pattern by adjacent conductive layer. That is, since the undercoat layer which is formed with so-called solder resist is thin, about 20 to 40»m in thickness, the distributed electrostatic capacity of signal pattern and power supply pattern with respect to the conductive layer which is formed thereon and connected to the ground pattern is significant. Accordingly, unnecessary high frequency component which is generated by ringing is grounded to the ground pattern with high frequency, so that the radiation noise is suppressed.

Thirdly, equalization of impedance of signal pattern and power supply pattern by conductive layer. That is, since the signal pattern and power supply pattern are covered by the conductive layer, the distance between these circuit patterns and the conductive layer connected to the ground pattern is equalized, and the impedance of each circuit pattern is equalized. As a result, impedance mismatch in high frequency transmission and generation of unnecessary high frequency component which is caused thereby are suppressed.

Another reason is a shield effect by conductive layer itself.

Owing to these four reasons, that is reduction of impedance of ground pattern by conductive layer, removal of high frequency component by adjacent conductive layer, equalization of impedance of circuit pattern and ordinary shield effect of conductive layer itself, the radiation noise can be effectively suppressed.

However, in the conventional printed circuit board employing conventional EMI preventing means, the width of the ground pattern led to the IC ground pattern is small, so that the impedance at high frequency is high, resulting in occurrence of potential difference along its length, and thereby, in unstable ground level of IC. As a result of fluctuation of this ground level, the radiation noise is caused, and by the same reason the radiation noise is caused in the output signal of IC. Due to this, sufficient effect of EMI preventing means cannot be obtained.

The layout of printed circuit board is varied depending on uses. Hence, in some cases the sufficient ground pattern area to connect a conductive layer cannot be provided. In these cases the area to connect the ground pattern and the conductive layer is small, and high frequency impedance is increased, resulting in reduction of effect. To prevent potential difference in the ground circuit, it is desirable to connect the ground pattern and the conductive layer in several places. If such a connection is impossible owing to restriction of layout, the requirement to EMI could not be satisfied sufficiently.

EP-A-0259785 proposes a circuit board having a circuit conductive pattern, a dielectric layer applied over the circuit conductive pattern, and a uniform voltage conductive pattern as the outermost conductive pattern and covering sufficient surface area of all underlying circuit conductive patterns to provide a shielding effect. The uniform voltage conductive pattern may be used as a power plane, a ground plane or the like, so long as the voltage is substantially constant as a function of time across the surface of the plane.

### SUMMARY OF THE INVENTION

According to the present invention there is provided a printed circuit board according to claim 1 and a method of manufacturing a printed circuit board according to claim 4. The remaining claims set out optional features.

An embodiment of the invention provides a printed circuit board having EMI preventing means even in the case when it is difficult to reduce the impedance owing to narrowness of the ground pattern leading to the IC ground pin, resulting from layout restrictions.

An embodiment of the invention provides a printed circuit board providing suppression of electromagnetic interference by connecting the conductive layer to the power supply pattern when the area for connecting the conductive layer to the ground pattern is restricted.

In an embodiment of the invention, an IC ground pin connection land, for an IC which is a noise source, is directly connected to the conductive layer so that the IC ground pin connection land is connected to another part of the ground pattern through the conductive layer. The high frequency impedance of the ground pattern between the ground pin connection land and the other part of the ground pattern is thereby lowered, so that the potential of the IC ground pin is stabilised and radiation noise generated by fluctuation of electric potential is suppressed. The radiation noise suppression effect is enhanced as the area of the ground pin connection land is increased, resulting in reduction of the impedance of the connection at the land.

Even on the EMI-prevented printed circuit board in which the conductive layer is connected to the power supply pattern in place of the ground pattern, the connection of the power supply pin connection land of the IC to another part of the power supply pattern through the conductive layer lowers the high frequency impedance of the power supply pattern between the connection land and the other part of the pattern, owing to the direct connection of the IC power supply pin connection land to the conductive layer. This stabilises the potential of the IC power supply pin so that radiation noise generated by fluctuation of potential can be suppressed.

The stabilisation of the reference potential of the IC is increased as the area of the IC power supply pin connection land is widened as compared with the area of an IC signal pin connection land, thereby to enhance the radiation noise suppression effect.

The distribution electrostatic capacitance between the signal pattern and the ground pattern on the one hand and the conductive layer connected to the power supply pattern on the other hand is increased, and the circuit impedance reduced, by connecting the conductive layer to the power supply pattern in place of the ground pattern. As a result, any unnecessary high frequency component caused by ringing is grounded to the power supply pattern which results in suppression of radiation noise. Since the signal pattern and ground pattern are wholly covered by the conductive layer connected to the power supply pattern, the impedance of each circuit is unified, and therefore the occurrence of impedance unmatching in high frequency transmission, and the generation of unnecessary high frequency components resulting therefrom, are suppressed.

Moreover, the ordinary shield effect given by the conductive layer itself is additionally present.

### BRIEF DESCRIPTION OF THE DRAWINGS

Figure 1 shows a cross-section of a printed circuit board according to an embodiment of the invention; and
Figure 2 shows a cross-section of a printed circuit board according to a further embodiment of the invention.

### Description of the preferred embodiment

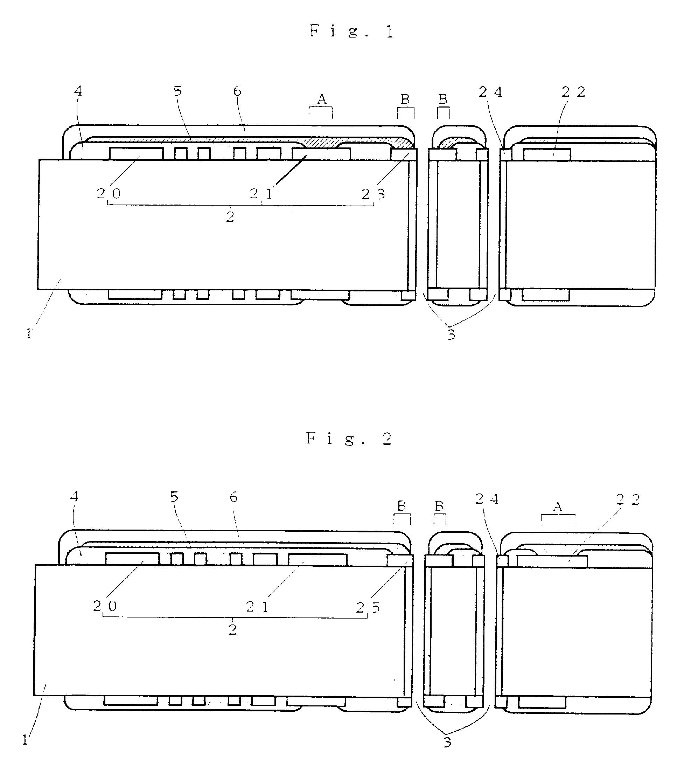

Fig. 1 shows a cross section of printed circuit board which is an embodiment of this invention. A circuit pattern 2 made of copper foil is formed on the upper surface of a substrate 1 which is composed of a insulation material such as epoxy resin, phenol resin, glass fiber or ceramics. This circuit pattern 2 includes a signal pattern 20, a ground pattern 21, a power supply pattern 22, an IC ground pin connection land 23 and an IC signal pin connection land 24. 3 in this figure is through hole. The area of IC ground pin connection land 23 included in the circuit pattern is larger by several times than the area of IC signal pin connection land 24. It is desirable that this IC ground pin connection land has the largest possible area (as large as allowed by the pattern layout). These patterns are formed by the known photolithography.

After formation of required pattern, an undercoat layer 4 is formed, leaving uncovered a partial area A of ground pattern 21 and a partial area B of IC ground pin connection land 23. This undercoat layer 4 is solder resist layer made of resin insulation material. The undercoat layer 4 can be easily formed by screen printing. After the undercoat layer is formed, a conductive paste layer 5 is formed thereon by screen printing. In this example of embodiment of this invention, the conductive layer is made of copper paste and is formed so as to cover almost whole surface of the undercoat layer 4. The material, for example, of the following composition, can be used for the copper paste. Other compositions are also applicable.

Basically, the copper paste is made by mixing the fine copper particles which serve as filler, binder designated to bond reliably these particles and various additives to maintain the conductivity stably for a long time. Concretely, it is prepared by mixing 100 wt. portion of metal copper powder, 10 to 25 wt. portion of resin mixture (consisting of 35 to 50 wt. % of melamine resin, 20 to 35 wt. % of polyester resin, and 15 to 30 wt. % of resole type phenol resin), 0.5 to 2 wt. portion of fatty acid or its metallic salt and 0.5 to 4 wt. portion of chelate forming agent. Metallic copper powder of flake, resin, spheric or amorphous type can be used. It is desirable that particle diameter be less than 100 »m, especially 1 to 30 »m.

After the conductive paste 5 is applied, it is heated to cure. Then the overcoat layer 6 made of insulation resin material is formed on the whole surface of conductive paste layer 5. This overcoat layer 6 can be made of the same material as that of undercoat layer 4. The conductive paste layer 5 and the undercoat layer 4 can be easily formed by printing.

In the composition mentioned-above the conductive paste layer 5 is directly connected to the IC ground pin connection land 23, so that potential of this IC ground pin is stabilized, and the generation of radiation noise by potential fluctuation is suppressed. As shown in Fig. 1, the IC ground pin connection land 23 is formed with wider area than that of IC signal pin connection land 24. Therefore impedance at the point of connection to the conductive paste layer 5 can be reduced more so that the radiation noise suppression effect can be enhanced.

In the embodiment shown in Fig. 1, the conductive paste layer 5 and the overcoat layer 6 are formed only on the front surface of substrate 1. As a matter of course, it is desirable to form these layers also on the rear side of substrate 1. As the conductive paste layer 5 connection areas A and B are increased, the suppression effect is enhanced.

Fig. 2 shows a further embodiment of this invention. Its composition differs from that of printed circuit board shown in Fig. 1 in that the IC pin connection land to be connected to the conductive paste layer 5 is IC power supply pin connection land 25 and that the part to be connected to the conductive paste layer5 is part of power supply pattern. Other parts are all the same as those shown in Fig. 1. When the printed circuit board has such a composition, the reference potential of IC is stabilized at the IC power supply pin. Accordingly, the same suppression effect as that obtained on the printed circuit board shown in Fig. 1 can be obtained.

In the embodiment mentioned above, the IC ground pin is directly connected to the conductive layer through the land. Therefore, the radiation noise suppression effect can be enhanced more as compared to the conventional EMI-prevented printed circuit board which is designed so that the IC ground pin is connected indirectly to the conductive layer through the ground pattern of substrate. The above-mentioned effect can be more enhanced by widening the area of IC ground pin connection land.

When the conductive layer cannot be connected to the ground circuit owing to restriction of layout but a sufficient area to connect it to the power supply pattern can be provided, the same EMI suppression effect as that of printed circuit board where the conductive layer is connected to the ground pattern can be obtained by connecting the above-mentioned conductive layer to this power supply pattern. Accordingly, even on the printed circuit board where the power supply pattern is connected to the conductive layer the EMI suppression effect can be obtained by increasing the area for IC power supply pin connection.

## Claims

1. A printed circuit board, comprising:
a substrate (1);
a circuit pattern (2) formed on the substrate (1) and including a signal line pattern (20) and a further pattern, which is one of (i) a power supply line pattern (22) and (ii) a ground line pattern (21);
an insulation layer (4) which is formed on the substrate (1) over the circuit pattern (2); and
a conductive layer (5) for connection to ground or a power supply potential, and formed on the insulation layer (4);
characterised in that:
(a) the insulation layer (4) is formed so as to cover the circuit pattern (2) except at least a part of the further pattern and except a land in the circuit pattern for an Integrated Circuit pin connection for the power supply (25) or for ground (23), respectively; and
(b) the conductive layer (5) is formed so as to be connected to an uninsulated part of the further pattern, and to the land for the said Integrated Circuit pin connection.

2. A printed circuit board according to claim 1, wherein the area of the said Integrated Circuit pin connection land (23, 25) is wider than a signal land (24) for an Integrated Circuit signal pin connection.

3. A printed circuit board according to claim 1 or claim 2 wherein the conductive layer (5) overlies substantially the whole of the insulation layer (4).

4. A method of manufacturing a printed circuit board comprising the steps of:
(a) printing a circuit on a substrate (1);
(b) forming an insulating layer (4) on said printed circuit (2); and
(c) forming a conductive layer (5) on the insulating layer (4),
characterised in that the printed circuit has a conductive part (23, 25) for contact to a ground pin or a power supply pin of a circuit component to be mounted on the board, the insulating layer is not formed at the said conductive part (23, 25) of the printed circuit (2), and the conductive layer (5) contacts the printed circuit (2) at the said conductive part (23, 25).

5. A method according to claim 4 in which the insulating layer (4) also is not formed over at least a part of a ground line (21) or a power line (22) of the printed circuit (2), and the conductive layer (5) also contacts the ground line (21) or power line (22) separately from its contact with the said conductive part (23, 25).

## Patentansprüche

1. Gedruckte Leiterplatte mit:
einem Substrat (1);
einem auf dem Substrat (1) geformten Leitungsmuster (2), das ein Signalleitungsmuster (20) und ein weiteres Muster, welches (i) ein Stromzuführleitungsmuster (22) oder (ei) ein Erdungsleitungsmuster (21) ist, umfaßt;
eine Isolierschicht (4), die auf dem Substrat (2) über dem Leitungsmuster (2) geformt ist, und
einer leitfähigen Schicht (5) zur Verbindung mit Masse oder einem Stromzuführungspotential, die auf der Isolierschicht (4) geformt ist;
dadurch **gekennzeichnet,** daß:
a) die Isolierschicht (4) so geformt ist, daß sie das Leitungsmuster (2) mit Ausnahme mindestens eines Teils des weiteren Musters und mit Ausnahme einer Erhöhung in dem Leitungsmuster für eine IC-Stiftverbindung für die Stromzuführung (25) bzw. für Erde (23); und
b) die leitfähige Schicht (5) so geformt ist, daß sie mit einem nichtisolierten Teil des weiteren Musters und mit der Erhöhung für die IC-Stiftverbindung verbunden ist.

2. Bedruckte Leiterplatte nach Anspruch 1, bei der die Fläche der Erhöhung (23, 25) für die IC-Stiftverbindung breiter ist als eine Signalanschlußerhöhung (24) für eine IC-Signalstiftverbindung.

3. Bedruckte Leiterplatte nach Anspruch 1 oder 2, bei der die leitfähige Schicht (7) im wesentlichen die gesamte Isolierschicht (4) überdeckt.

4. Verfahren zur Herstellung einer gedruckten Leiterplatte mit den Schritten:
a) Aufdrucken einer Schaltung auf ein Substrat (1);
b) Aufbringen einer Isolierschicht (4) auf der gedruckten Schaltung (2); und
c) Aufbringen einer leitfähigen Schicht (5) auf der Isolierschicht (4),
dadurch **gekennzeichnet,** daß die gedruckte Schaltung einen leitfähigen Teil (23, 25) zur Kontaktierung mit einem Erdungsstift oder einem Stromzuführungsstift einer auf der Platte zu montierenden Schaltungskomponente, wobei die isolierende Schicht nicht auf diesem leitfähigen Teil (23, 25) der gedruckten Schaltung (25) ausgebildet ist, und die leitfähige Schicht (5) der gedruckten Schaltung (2) an diesem leitfähigen Teil (23, 25) kontaktiert.

5. Verfahren nach Anspruch 4,
bei dem die Isolierschicht (4) auch über mindestens einen Teil einer Erdungsleitung (21) oder einer Stromzuführleitung (22) der gedruckten Schaltung (2) nicht ausgebildet ist und die leitfähige Schicht (5) auch die Erdungsleitung (21) oder Stromzuführleitung (22) getrennt von ihrem Kontakt mit dem leitfähigen Teil (23, 25) kontaktiert.

## Revendications

1. Une carte à circuit imprimé comprenant:
un substrat (1);
une trace de circuit (2) formée sur le substrat (1) et comprenant une trace de ligne de signal (20) ainsi qu'une trace supplémentaire qui est soit (i) une trace d'alimentation (22), soit (ii) une trace de masse (21);
une couche isolante (4) qui est formée sur le substrat (1) sur la trace de circuit (2); et
une couche conductrice (5) destinée à être raccordée à la tension de masse ou à la tension d'alimentation, et formée sur la couche isolante (4);
caractérisée en ce que:
a) on forme la couche isolante (4) de manière à recouvrir la trace de circuit (2) sauf en au moins une partie de ladite trace supplémentaire, et sauf en une pastille de la trace de circuit pour le raccordement d'une broche de circuit intégrée à l'alimentation (25) ou, respectivement, à la masse (23), et
b) on forme la couche conductrice (5) afin d'assurer son raccordement à une partie non isolée de la trace supplémentaire, ainsi qu'à la pastille pour le raccordement de ladite broche de circuit intégré.

2. Une carte à circuit imprimé selon la revendication 1, dans laquelle la surface de ladite pastille de raccordement de la broche de circuit intégré (23, 25) est plus large qu'une pastille de signal (24) pour le raccordement d'une broche de signal de circuit intégré.

3. Une carte à circuit imprimé selon la revendication 1 ou 2 dans laquelle la couche conductrice (5) recouvre sensiblement l'intégralité de la couche isolante (4).

4. Un procédé de fabrication d'une carte à circuit imprimé comprenant les étapes consistant à:
a) imprimer un circuit sur un substrat (1);
b) former une couche isolante (4) sur ledit circuit imprimé (2); et
c) former une couche conductrice (5) sur la couche isolante (4),
caractérisé en ce que le circuit imprimé présente une partie conductrice (23, 25) destinée à venir en contact avec une broche de masse ou une broche d'alimentation d'un composant électronique destiné à être monté sur la carte, la couche isolante n'étant pas formée à ladite partie conductrice (23, 25) du circuit imprimé (2), et la couche conductrice (5) venant en contact avec le circuit imprimé (2) à ladite partie conductrice (23, 25).

5. Un procédé selon la revendication 4 dans lequel on ne forme pas non plus la couche isolante (4) sur au moins une partie d'une ligne de masse (21) ou d'une ligne d'alimentation (22) du circuit imprimé (2), et la couche conductrice (5) vient également en contact avec la ligne de masse (21) ou la ligne d'alimentation (22) indépendamment de son contact avec ladite partie conductrice (23, 25).
